# EUROPÄISCHE PATENTSCHRIFT

(11) **EP 1 963 704 B1**
(45) Veröffentlichungstag und Bekanntmachung des Hinweises auf die Patenterteilung: **04.08.2010**
(21) Anmeldenummer: 06818959.6
(22) Anmeldetag: 01.12.2006
(51) Int. Cl.: F16F 7/10, B06B 1/06, H01L 41/09

(54) **KRAFTGENERATOR**
FORCE GENERATOR
GÉNÉRATEUR DE FORCE

(30) Priorität: 16.12.2005 DE 102005060779
(43) Veröffentlichungstag der Anmeldung: 03.09.2008
(73) Patentinhaber: EUROCOPTER DEUTSCHLAND GmbH, 86609 Donauwörth (DE)
(72) Erfinder: KONSTANZER, Peter, 82024 Taufkirchen (DE); STORM, Stefan, 85716 Unterschleissheim (DE)
(74) Vertreter: GPI & Associés
(86) Internationale Anmeldenummer: PCT/EP2006/011569
(87) Internationale Veröffentlichungsnummer: WO 2007/073820

(56) Entgegenhaltungen:
- EP-A- 1 528 281
- EP-A2- 0 907 036
- WO-A-02/31378
- WO-A-2005/087392
- DE-A1- 2 036 979
- DE-A1-102004 001 470
- GB-A- 2 265 669
- JP-A- 1 257 900
- JP-A- 2 127 696
- JP-A- 7 168 631
- JP-A- 10 322 424
- JP-A- 2004 130 270
- SU-A1- 1 467 286
- US-A- 4 626 730
- US-A- 5 245 245
- US-A- 5 945 772

## Beschreibung

Die Erfindung betrifft einen Kraftgenerator und ein Verfahren zum Betreiben des Kraftgenerators. Der Kraftgenerator dient insbesondere zur Schwingungsbeeinflussung von Strukturen, wobei gezielt Gegenschwingungen in eine Struktur eingeleitet werden, um den Gesamtpegel der Schwingungen in der Struktur zu reduzieren. Ferner betrifft die Erfindung eine Vorrichtung zur Schwingungsbeeinflussung. Die Erfindung findet insbesondere Anwendung bei der Schwingungskontrolle in Hubschraubern und Flugzeugen.

Kraftgeneratoren dienen dazu, mittels einer vorbestimmten Inertialmasse eine gewünschte Kraft zu erzeugen. Die Kraft resultiert dabei stets aus der Trägheit der wie auch immer bewegten Inertialmasse. Um eine möglichst hohe Kraft zu erzeugen, kann zum einen die Inertialmasse mit einer möglichst hohen Beschleunigung (bzw. hohen Auslenkung) bewegt werden. Alternativ dazu oder zusätzlich lässt sich eine solche hohe Kraft auch durch eine möglichst hohe Inertialmasse generieren.

Bisher sind Kraftgeneratoren bekannt, die auf dem elektrodynamischen Prinzip basieren, bei dem die Wechselwirkung zwischen bewegten elektrischen Ladungen genutzt wird. In einem Magnetfeld ist dazu ein zu einer Spule aufgewickelter elektrischer Leiter eingetaucht, der mit einem Strompuls versehen wird. Die Ladungen im Leiter erfahren daraufhin einen Kraftstoß, wodurch die Spule in Bewegung versetzt wird. Dabei besteht ein Nachteil darin, dass die Spule eine hohe Masse besitzt und nur relativ geringe Beschleunigungen und damit geringe Kräfte generieren kann. Das Verhältnis aus eingesetzter Masse zu erzeugter Kraft ist relativ hoch. Ferner besteht eine ungünstige Energiebilanz bei elektrodynamischen Prinzipien aufgrund des ohmschen Widerstands der Spule.

Derartige Kraftgeneratoren werden beispielsweise zum gezielten Einleiten von Kräften in schwingende Strukturen (z. B. Luftfahrzeuge, Kraftfahrzeuge oder Maschinenkomponenten) verwendet, um hohen Schwingungspegeln entgegenzuwirken und diese auszulöschen. Dabei treten insbesondere dann Probleme auf, wenn die Frequenz der zu regelnden Struktur mehr oder weniger stark variiert, wie es beispielsweise bei unterschiedlichen Betriebszuständen der schwingenden Struktur der Fall ist. Derartige unterschiedliche Betriebszustände treten zum Beispiel bei Luftfahrzeugen in den unterschiedlichen Flugphasen auf, Insbesondere beim Start sowie bei der Landung. Mit den bekannten Anordnungen können Schwingung meist nur in einem sehr engen Frequenzbereich reduziert werden, was in vielen Anwendungsfällen von Nachteil ist.

JP 7 168631 A offenbart einen Kraftgenerator, der zur Anbringung an einer Struktur ausgebildet ist, um steuerbar Schwingungskräfte zur Schwingungsbeeinflussung der Struktur in diese einzuleiten mit einem Biegearm, der an einem Ende an der Struktur befestigt ist und eine Inertialmasse, die entfernt vom Befestigungsende des Biegearms mit dem Biegearm gekoppelt ist.

JP 10322424 offenbart ein piezoelektrisches Element, das an vorderen und hinteren Seiten einer elastischen Platte angebracht wird und eine Masse, die an einem Ende der elastischen Platte befestigt wird.

EP 0 907 036 A2 offenbart einen mechanischen Resonator mit einer Feder, die zumindest auf einer Seite gespannt Ist und eine angefügte Masse, die jeweils oder zusammen mit einem elektromechanischen Umformer verbunden sind und einen Bewegungs- und/oder Beschleunigungssensor, der die Bewegung- und/oder Beschleunigung der Feder und/oder der Masse erfasst.

JP 1257900 A offenbart polarisierte piezoelektrische Platten, die an oberen und entgegengesetzten Oberflächen einer rechteckigen metallischen Platte angebracht sind. Electroden sind auf den Oberflächen gebildet und Gewichte sind an zwei offene Enden der metallischen Platte angebracht.

Eine Aufgabe der Erfindung ist es, einen Kraftgenerator zu schaffen, der bei einer vorgegebenen Inertialmasse hohe Beschleunigungen und damit Kräfte generiert und gleichzeitig ein günstiges Verhältnis aus Inertialmasse und damit erzeugter Kraft aufweist. Der erfindungsgemässe Kraftgenerator soll zudem eine hohe Güte aufweisen, d.h. eine geringe Eigendämpfung und einen geringen Energieverbrauch haben. Eine weitere Aufgabe besteht darin, einen Kraftgenerator zu schaffen, der universell und variabel einsetzbar ist; d.h., mit dem insbesondere Schwingungen über einen möglichst weiten Frequenzbereich wirksam vermindert werden können. Es besteht ferner eine Aufgabe darin, ein Verfahren anzugeben, mit dem ein solcher Kraftgenerator betrieben werden kann.

Diese Aufgaben werden durch einen Kraftgenerator mit den Merkmalen der unabhängigen Ansprüche gelöst. In davon abhängigen Ansprüchen sind vorteilhafte Ausgestaltungen der Erfindung angegeben.

Der erfindungsgemässe Kraftgenerator ist zur Anbringung an einer Struktur ausgebildet, um steuerbar Schwingungskräfte zur Schwingungsbeeinflussung der Struktur in diese einzuleiten, und umfasst einen Biegearm, der mindestens an dessen einem Ende an der Struktur befestigbar ist, sowie eine Inertialmasse, die vom Befestigungsende des Biegearmes entfernt mit dem Biegearm gekoppelt ist. Der Biegearm ist mit einem elektromechanischen Wandler versehen, und eine Ansteuerung für den elektromechanischen Wandler ist vorgesehen, welche eingerichtet ist, durch Ansteuern des elektromechanischen Wandlers den Biegearm mit der Inertialmasse und dem Wandler derart zu verbiegen und dadurch die Inertialmasse auszulenken, dass Schwingungskräfte mit variabler Amplitude, Phase und Frequenz in die Struktur erzeugbar sind, die über das Befestigungsende in die Struktur einleitbar sind.

Besonders vorteilhaft ist dabei, dass die Ansteuerung eingerichtet, die Inertialmasse, den Biegearm und den elektromechanischen Wandler in eine Schwingung mit verstellbarer Amplitude, Phase und Frequenz zu versetzen. Auf diese Wiese können gezielt unterschiedliche Schwingungskräfte, insbesondere über einen weiten Frequenzbereich, generiert und in eine zu beeinflussende Struktur eingeleitet werden. Dabei ist es möglich, die Inertialmasse und den Biegearm einschließlich Wandler entweder weniger stark anzuregen, so dass eine niedrigere Schwingungsamplitude und damit niedrigere Beschleunigung und niedrigere Kraft erreicht wird, oder aber auch stark zu erregen, so dass eine hohe Schwingungsamplitude und damit große Beschleunigung und große Kraft erreicht wird. Neben der Anpassung der Schwingungsamplitude ist ebenso die Phase als auch die Frequenz variabel einstellbar.

Ein weiterer Vorteil besteht darin, dass der elektromechanischen Wandler auch derart angesteuert werden kann, dass ein Einleiten von Schwingungskräften bei zwei oder mehreren Frequenzen gleichzeitig möglich ist. Dabei erfolgt die Ansteuerung bei mehreren Frequenzen oder über einen vorgegebenen Frequenzbereich.

Wird der Kraftgenerator in Eigenfrequenz (bzw. in der Nähe seiner Eigenfrequenz/en) betrieben, kann dadurch vorteilhafterweise die dynamische Überhöhung der Auslenkung der Inertialmasse zur Generierung besonders hoher Kräfte ausgenutzt werden. Durch die Anregung im Bereich der Eigenfrequenz kann bei vorbestimmter Inertialmasse eine hohe Schwingungsamplitude der Inertialmasse erreicht werden. Damit geht eine hohe Beschleunigung einher, so dass relativ hohe Kräfte von der Inertialmasse generiert werden können. Zweckmäßigerweise beträgt die Inertialmasse ein Vielfaches der Masse des Biegearmes einschließlich Wandler, so dass der Kraftgenerator eine relativ geringe Gesamtmasse besitzt und eine hohe Effizienz erreicht.

Vorzugsweise ist der Wandler ein piezoelektrischer Aktuator. Ein solcher Aktuator besitzt ein sehr schnelles Ansprechverhalten und ist sowohl hinsichtlich seiner Stellwegamplituden als auch seiner Frequenzen präzise regelbar. Damit lassen sich für den Kraftgenerator genau vorbestimmte Erregerfrequenzen einstellen. Ein piezoelektrischer Aktuator arbeitet auch bei hohen Gegenkräften mit hohen Stellwegen und hoher Auflösung, so dass auch bei großer Inertialmasse zuverlässig Schwingungskräfte erzeugt werden können.

Besonders bevorzugt ist der piezoelektrische Aktuator ein stapelförmiges Piezoelement (d.h. ein sogenannter "Piezostack") mit d33-Effekt. Bei dem d33-Effekt, der bekanntlich auch als Longitudinaleffekt bezeichnet wird, erfolgt die Längenänderung des piezoelektrischen Elements in Richtung des angelegten elektrischen Feldes, d.h. entlang der Stapel- bzw. Längsrichtung des Piezoelements. Die dabei hervorgerufene Längenänderung ist bekanntlich größer als die Längenänderung beim d31-Effekt, bei dem die Längenänderung quer zur Richtung des angelegten elektrischen Feldes erfolgt.

Gemäß einer bevorzugten Ausführungsform ist der Wandler so ansteuerbar, dass er eine Längenänderung in Längsrichtung des Biegearmes durchführt. Dies führt zu einer Verbiegung des Biegearms, wodurch wiederum die Inertialmasse ausgelenkt wird, so dass Schwingungen des Biegearms mit der Inertialmasse und dem Wandler angestoßen werden, um entsprechende Schwingungskräfte zu generieren. Ist der Wandler parallel zu einer Neutrallage angeordnet, welche bei einem symmetrisch aufgebauten Biegearm entlang der Mittellinie des Biegearms verläuft, lässt sich damit eine parallel zur Neutrallage vorgesehene Lage im Vergleich zur Neutrallage in ihrer Länge verändern. Die Lage mit der größeren Länge induziert eine Durchbiegung in Richtung zur Lage mit der kürzeren Länge. Wird die Längenänderung in periodischen Abständen wiederholt, entsteht eine Biegeschwingung des Biegearmes einschließlich Wandler und Inertialmasse. Bei einer Anregung im Eigenfrequenzbereich schwingt das System zu großen Amplituden auf.

Besonders bevorzugt ist jeweils mindestens ein Wandler auf einander gegenüberliegenden Seiten der Neutrallage angeordnet, so dass eine Durchbiegung zu beiden einander gegenüberliegenden Seiten der Neutrallage hin erzeugt wird, wodurch vorteilhafterweise die Auslenkung der Inertialmasse vergrößert werden kann.

Vorzugsweise ist der Wandler mit der Neutrallage kraftschlüssig und/oder formschlüssig verbunden. Damit ist zum einen sichergestellt, dass der Wandler ortsfest positioniert ist und eine genau wiederholbare Verbiegung des Biegearmes bewirken kann. Zum anderen wird durch die Positionierung des Wandlers in der Nähe der Neutrallage erreicht, dass bei sehr hohen Schwingungsamplituden der Wandler relativ wenig durchgebogen wird. Dies ist eine Maßnahme zum Schutz des Wandlers vor mechanischer Deformation durch Biegung. Der Schutz kann erhöht werden, wenn der mindestens eine Wandler innerhalb des Biegearmes angeordnet bzw. in diesen eingebettet ist. Eine Verletzung eines mechanisch empfindlichen Wandlers von außerhalb ist damit nur erschwert möglich. Zusätzlich kann durch die Anordnung des Wandlers innerhalb des Biegearmes eine Kapselung des Wandlers erreicht werden, so dass der Kraftgenerator auch z.B. in nasser oder chemisch aggressiver Umgebung verwendbar ist.

Gemäß der Erfindung ist zwischen einem Ende des Wandlers und der Inertialmasse ein Distanzelement angeordnet. Durch das Distanzelement kann der Wandler noch sicherer in seiner Lage positioniert werden. Vorzugsweise weist das Distanzelement eine geringe Dichte auf, um das Verhältnis aus Inertialmasse zur Masse des Biegearmes einschließlich Wandler zu erhöhen. Insbesondere kann durch geeignete Wahl des Materials für das Distanzelement die Eigenfrequenz der Baugruppe aus Biegearm, Wandler und Inertialmasse gezielt beeinflusst werden.

Zusätzlich ist eine schützende Außenlage des Biegearmes, welche zur Neutrallage seitlich beabstandet angeordnet ist, mit dem Wandler kraftschlüssig und/oder formschlüssig verbunden. Durch den Einsatz einer Außenlage wird eine Schichtbauweise des Biegearmes und damit ein einfacher Schutz vor äußeren Einflüssen auf den Wandler erreicht. Die kraftschlüssige Verbindung, wie zum Beispiel durch Verkleben, und die formschlüssige Verbindung, wie zum Beispiel durch Verschrauben, stellen eine genaue Positionierung der Teile zueinander sicher.

Besonders bevorzugt ist der Biegearm in Faserverbundbauweise mit integriertem Wandler ausgebildet. Der Biegearm wird dabei in Schichtbauweise unter Verwendung von Faserverbundwerkstoffen, insbesondere glasfaserverstärktem Kunststoff (GFK), hergestellt, wobei der Schichtaufbau in einem letzten Arbeitschritt beispielsweise mittels bekanntem RTM- ("Resin Transfer Moulding") Verfahren mit einem Harzsystem infiltriert bzw. injiziert und anschließend ausgehärtet wird. Durch eine derartige Faserverbundbauweise wird eine besonders hohe Lebensdauer des Kraftgenerators erzielt.

Vorzugsweise steht der Wandler unter einer Druckvorspannung. Damit wird erreicht, dass auf den Wandler auch bei einer hohen Schwingungsamplitude (z.B. bei Resonanzüberhöhung) des Biegearmes stets Druckkräfte und keine für den Wandler gefährlichen Zugkräfte einwirken. Dies ist besonders bei einem Wandler von Bedeutung, der piezokeramische Schichten aufweist. Der unter Druckvorspannung stehende Wandler kann hohe Schwingungsamplituden besser überstehen. Die Druckvorspannung kann mechanisch aufgeprägt sein. Der Wandler kann aber auch thermisch vorgespannt werden. Dies lässt sich zum Beispiel dadurch erreichen, dass er in eine Matrix eingesetzt ist, die einen anderen Wärmeausdehnungskoeffizienten besitzt als der Wandler. Beim Warmaushärten der Matrix kann dann auf den Wandler eine Druckvorspannung erzielt werden. Eine andere Möglichkeit besteht darin, an den Wandler eine elektrische Offset-Spannung anzulegen. Damit ist der Wandler immer einer Kompression ausgesetzt und auch bei hohen Schwingungsamplituden vor einer Zugbelastung geschützt.

Der erfindungsgemäße Kraftgenerator weist typischerweise eine Länge von 3 bis 60 Zentimetern auf. Die Inertialmasse ist dann bei geeigneter Dimensionierung aller Bauteile beispielsweise in eine Schwingung versetzbar, die eine maximale Schwingungsamplitude im Bereich von 0,1 bis 3 Zentimetern aufweist.

Die Aufgabe wird auch durch ein Verfahren zum Betreiben des wie vorstehend beschriebenen Kraftgenerators gelöst, wobei durch geeignete Ansteuerung des elektromechanischen Wandlers der Biegearm mit der Inertialmasse und dem Wandler derart verbogen wird und dadurch die Inertialmasse ausgelenkt wird, dass Schwingungskräfte mit variabler Amplitude, Phase und Frequenz erzeugt werden.

Die Aufgabe der Erfindung wird auch durch eine Vorrichtung zur Schwingungsbeeinflussung gelöst, die zur Anbringung an zumindest einer Struktur ausgebildet ist, um steuerbar Schwingungskräfte in die Struktur einzuleiten, wobei zwei Kraftgeneratoren der oben beschriebenen Art derart angeordnet sind, dass der Biegearm des ersten Kraftgenerators in Verlängerung des Biegearms des zweiten Kraftgenerators angeordnet ist.

Somit kann der erfindungsgemäße Kraftgenerator auch in einer symmetrischen Bauweise eingesetzt werden, wobei zwei individuelle Kraftgeneratoren n beschriebenen Art derart verwendet werden, dass die jeweils nicht mit der Inertialmasse gekoppelten Enden der Biegearme an einer schwingungsmäßig zu beeinflussenden Struktur befestigt sind oder derart miteinander verbunden sind, das sie einen Biegearm mit beidseitig, d.h. an beiden Enden eines Biegearms, angeordneten Inertialmassen bilden. Dabei sollten die Inertialmassen einen gleichen Anstand zur Struktur aufweisen, d.h. die Hebelarme der Biegearme sind vorzugsweise identisch. Die Anordnung kann so angesteuert werden, dass die Inertialmassen parallel, d.h. in gleiche Richtung, oder anti-parallel, d.h. in entgegengesetzte Richtungen, ausgelenkt werden. In letzterem Fall können nicht nur Kräfte sondern auch Momente in die Struktur eingeleitet werden.

Eine weitere symmetrische Verwendung des erfindungsgemäßen Kraftgenerators ist die nachfolgend auch als "Durchschwinger" bezeichnete Anordnung, bei der Biegearm eines ersten Kraftgenerators quasi über die Inertialmasse hinaus verlängert ist, und das freie Ende des verlängerten Biegearms ebenfalls mit der Struktur, aber an andere Stelle, befestigt ist. Mit anderen Worten, es ist eine Biegearm vorgesehen, dessen gegenüberliegende Enden an einer Struktur befestigbar sind, wobei vorzugsweise in der Mitte des Biegearms zumindest eine Inertialmasse vorgesehen ist. Bei einer derartigen Anordnung erfolgt das Einleiten von Kräften momentenfrei.

Der erfindungsgemäße Kraftgenerator sowie seine symmetrische Verwendung werden insbesondere zu aktiven Schwingungsregelung von Strukturen (Luftfahrzeugen, Kraftfahrzeugen, Maschinenkomponenten etc.) eingesetzt.

Weitere Merkmale und Vorteile der Erfindung ergeben sich aus der folgenden Beschreibung verschiedener, erfindungsgemäßer Ausführungsbeispiele im Zusammenhang mit den begleitenden Zeichnungen. Darin zeigen:
- **Fig. 1**: eine schematische Darstellung eines Kraftgenerators in einer Ruheposition;
- **Fig. 2**: eine schematische Darstellung des Kraftgenerators aus Fig. 1 in einer durchgebogenen Position;
- **Fig. 3**: eine schematische Darstellung einer ersten Ausführungsform des erfindungsgemäßen Kraftgenerators in einer Ruheposition;
- **Fig. 4**: eine schematische Darstellung der ersten Ausführungsform des Kraftgenerators aus Fig. 3 in einer durchgebogenen Position;
- **Fig. 5**: eine schematische Darstellung einer zweiten Ausführungsform des erfindungsgemäßen Kraftgenerators in einer Ruheposition;
- **Fig. 6**: eine schematische Darstellung der zweiten Ausführungsform des Kraftgenerators aus Fig. 5 in einer durchgebogenen Position;
- **Fig. 7**: eine schematische Darstellung einer dritten Ausführungsform des erfindungsgemäßen Kraftgenerators in einer Ruheposition; und
- **Fig. 8**: eine schematische Darstellung einer weiteren erfindungsgemäßen Ausführungsform, die zwei symmetrisch angeordnete Kraftgeneratoren umfasst; und
- **Fig. 9**: eine zu Fig. 8 alternative symmetrische Anordnung von zwei Kraftgeneratoren.

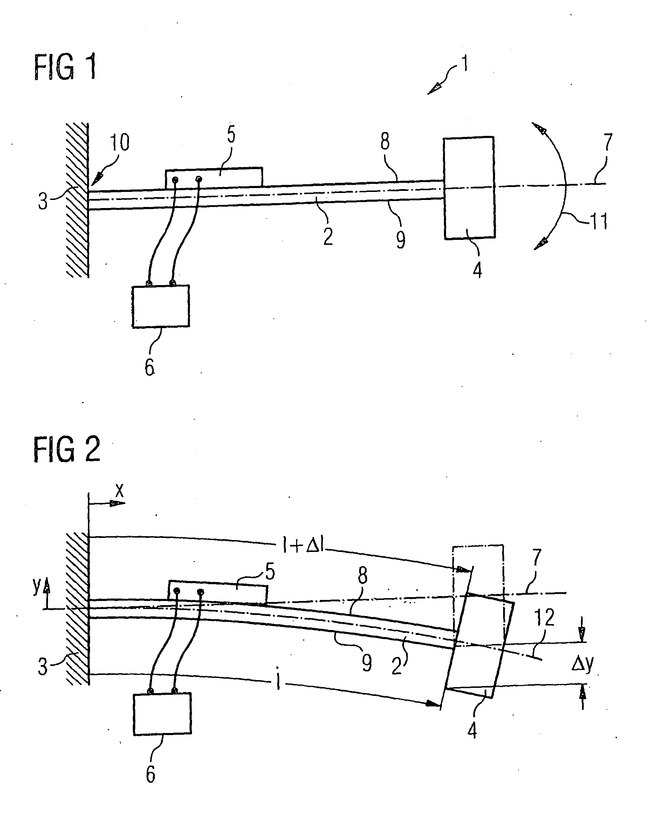

In Fig. 1 ist in schematischer Darstellung ein Kraftgenerator 1 dargestellt. Er weist einen Biegearm 2 auf, der an einem Ende 10 an einer Struktur 3 befestigt ist und am anderen Ende eine Inertialmasse 4 aufweist. Die Struktur 3 ist beispielsweise ein Luftfahrzeug, ein Kraftfahrzeug, eine Maschinenkomponente oder ein beliebig anderes Bauteil, wobei die Struktur 3 in unerwünschter Weise schwingt. Zur Reduzierung dieser Schwingungen ist der Kraftgenerator 1 mit der Struktur 3 verbunden, so dass gezielt Gegenschwingungen in die Struktur 3 eingeleitet werden können, um den Gesamtpegel der Schwingungen in der Struktur 3 zu reduzieren, wie nachfolgend in näheren Einzelheiten erläutert wird.

Auf dem Biegearm 2 ist ein elektromechanischer Wandler 5 montiert, insbesondere ein piezoelektrischer Aktuator, der mit einer Ansteuerung 6 elektrisch verbunden ist. Die Position der Ansteuerung 6 ist vom Biegearm 2 und vom Wandler 5 in einem solchen Abstand angeordnet, dass sie eine Bewegung des Biegearms 2 einschließlich Wandler 5 und Inertialmasse 4 nicht behindert. Der Biegearm 2 befindet sich zusammen mit der Inertialmasse 4 und dem elektromechanischen Wandler 5 bei der in Fig.1 dargestellten Position in einer Ruheposition, wobei die Mittellinie 7 des Biegearms 2 horizontal verläuft.

Der elektromechanische Wandler 5 wird derart angesteuert, dass er eine positive Längenänderung Δl in Längsrichtung des Biegearms 2 erfährt. Dabei ist der Wandler 5 mit der oberen Randfaser 8 des Biegearms 2 so verbunden, dass die Längenänderung Δl des Wandlers 5 in die obere Randfaser 8 übertragen wird, so dass sich deren Länge I um Δl verlängert. Da auf die untere Randfaser 9 keine Längenänderung ausgeübt wird, ergibt sich damit zwischen oberer Randfaser 8 und unterer Randfaser 9 eine Längendifferenz von Δl. Wie aus Fig. 2 ersichtlich ist, führt diese Längendifferenz Δl zu einer Verbiegung des Biegearmes 2 in die negative y-Richtung. Die starr mit dem Biegearm 2 verbundene Inertialmasse 4 wird dabei von ihrer mit gestrichelter Linie dargestellten Ruheposition in eine mit durchgezogener Linie dargestellte durchgebogene Position um den Betrag Δ*y* verlagert. Als Folge der Längenzunahme um Δl der oberen Randfaser 8 ändert somit die Mittellinie 7 des Biegearmes 2 ihren horizontalen Verlauf in die mit strichpunktierter Linie 12 dargestellte durchgebogene Position. Durch eine zumindest kraftschlüssige Verbindung von Wandler 5 und Biegearm 2 folgt dabei der Wandler 5 der Krümmung der oberen Randfaser 8.

Durch entsprechende Ansteuerung des Wandlers 5 kann folglich der Biegearm 2 einschließlich des Wandlers 5 und der Inertialmasse 4 zu einer Schwingung angeregt werden, bei der die Inertialmasse 4 und der Biegearm 2 mit dem Wandler 5 um die in der Horizontalen verlaufende Mittellinie 7 auf und ab schwingen, wie dies mit Pfeil 11 in Fig. 1 angedeutet ist. Dabei sind die Amplitude, Phase und Frequenz der Schwingung durch geeignete Ansteuerung (z.B. U(ω) oder U (Δω)) des Wandlers 5 einstellbar, so dass über die Befestigungsstelle 10 in die Struktur 3 gezielt Schwingungskräften einleitbar sind, um durch Überlagerung von eingeleiteten und Struktur-Schwingungen eine Reduzierung, im Idealfall Auslöschung, der Schwingungen über einen weiten Frequenzbereich und/oder bei mehreren Frequenzen gleichzeitig zu bewirken. Zur Regelung der Ansteuerung ist zumindest ein Sensor (nicht dargestellt) vorgesehen, der die Schwingungen der Struktur 3 erfasst, um basierend auf den erfassten Sensorsignalen die Ansteuerung 6 zu regeln.

Erfolgt die Ansteuerung des Wandlers 5 bzw. die Längenänderung Δl mit einer Frequenz, welche im Bereich der Eigenfrequenz des Systems aus Biegearm 2, Inertialmasse 4 und Wandler 5 liegt, kann die Inertialmasse 4 um einen Betrag in y-Richtung ausgelenkt werden, der durch Resonanzüberhöhung um ein Mehrfaches höher ist als der Betrag Ay. Durch die höhere Schwingungsamplitude erfährt die Inertialmasse 4 eine größere Beschleunigung, so dass wesentliche größere Kräfte bzw. höhere Schwingungsamplituden erzeugt werden.

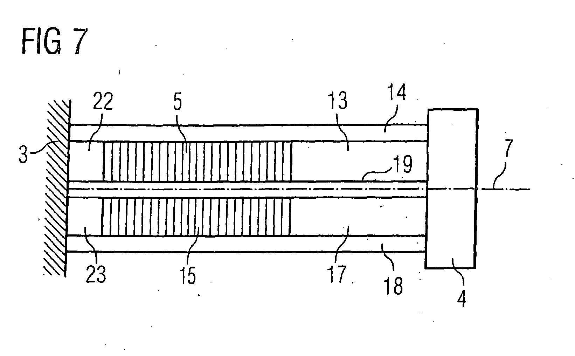

Bei dem in Fig. 1 und 2 dargestellten Kraftgenerator ist der elektromechanische Wandler 5 vorzugsweise ein stapelförmiges Piezoelement mit d33-Effekt. Die Stapelrichtung erstreckt sich dabei im Wesentlichen in Längsrichtung des Biegearms 2, d.h. in horizontaler Richtung, um die oben beschriebene Längenänderung Δl in Längsrichtung des Biegearms 2 hervorzurufen. Der Wandler 5 ist kraftschlüssig mit dem Biegearm 2 verbunden, z.B. durch Kleben. Alternativ kann in dem Biegearm 2 eine Aussparung (nicht dargestellt) vorgesehen sein, in die der Wandler 5 derart eingepasst ist, dass ein horizontales Verschieben oder Verrutschen des Wandlers 5 nicht möglich ist. Zum Schutz des Wandlers 5 kann die Anordnung aus Biegearm 2 und Wandler 5 zusätzlich mit einer Schutzschicht (nicht dargestellt) versehen oder in eine Faserverbundwerkstoff-Anordnung eingebettet sein, wobei letzteres im Zusammenhang mit der Beschreibung von Fig. 7 noch näher erläutert wird.

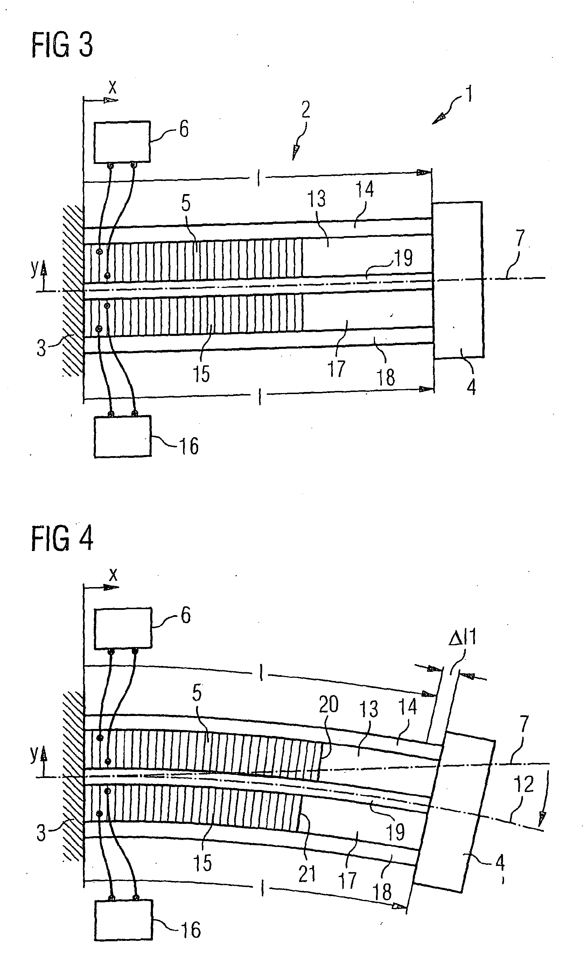

In Fig. 3 ist eine erste Ausführungsform des Kraftgenerators gemäß der Erfindung dargestellt. Der Biegearm 2 ist in Schichtbauweise aufgebaut. Er weist eine Neutrallage 19 auf, die entlang der Mittellinie 7 des Biegearmes 2 verläuft. Parallel dazu weist der Biegearm 2 eine obere Außenlage 14 und eine untere Außenlage 18 auf. Zwischen der oberen Außenlage 14 und der Neutrallage 19 sind ein erster Aktuator als elektromechanischer Wandler 5 und ein zusätzliches Element 13 angeordnet, das nachfolgend auch als Distanzelement bezeichnet wird, welches den Abstand zwischen Aktuator 5 und Inertialmasse 4 sowie den Abstand zwischen Neutrallage 19 und oberer Außenlage 14 auffüllt. In gleicher Weise befindet sich zwischen der Neutrallage 19 und der unteren Außenlage 18 ein zweiter Aktuator 15 und ein dran angrenzendes Distanzelement 17. Der erste Aktuator 5 ist mit einer Ansteuerung 6 und der zweite Aktuator 15 mit einer Ansteuerung 16 gekoppelt, die jeweils in Abhängigkeit von Sensorsignalen, die von entsprechenden Sensoren (nicht dargestellt) zur Erfassung der Schwingung der Struktur (3) aufgenommen werden, geregelt werden. Die Ansteuersignale für die Ansteuerungen 6, 16 können dabei identisch oder verschieden (z.B. U(ω₁) und U(ω₂)) sein, wobei jeder einzelnen Wandler 5, 15 auch bei mehreren Frequenzen gleichzeitig angeregt werde kann.

Bei der in Fig. 3 dargestellten Ausführungsform sind die Wandler 5, 15 wiederum als piezoelektrische Aktuatoren, insbesondere als stapelförmige Piezoelemente mit d33-Effekt, ausgebildet. Die Stapel- bzw. Längsrichtung des Piezoelements verläuft in horizontaler Richtung, so dass beim Anlegen eines elektrischen Feldes in Stapelrichtung des Piezoelements 5 ein Längenänderung in Längsrichtung des Biegearms 2 erfolgt. Die in Fig. 3 dargestellte Ruheposition des Kraftgenerators 1 kann durch eine Ansteuerung des ersten piezoelektrischen Aktuators 5 in eine durchgebogene Position verlagert werden. Erfährt der erste Aktuator 5 eine Längenänderung Δl1, siehe vorderes Ende 20 des ersten Aktuators 5, wird diese Längenänderung Δl1 aufgrund der Kopplung mit dem Distanzelement 13 und der oberen Außenlage 14 bis zur Inertialmasse 4 übertragen. Gleichzeitig erfährt der parallel dazu angeordnete zweite Aktuator 15 keine Längenänderung, siehe vorderes Ende 21 des zweiten Aktuators 15, so dass die untere Außenlage 18 in ihrer Länge nicht verändert wird. Wie bei dem in Fig. 2 dargestellten Kraftgenerator wird der Biegearm auf diese Wiese in negative y-Richtung verbogen, siehe Fig. 4. Ansonsten ist die Wirkungsweise und Funktion des Kraftgenerators 1 analog zur der des Krafgenerators gemäß Fig. 1 und 2.

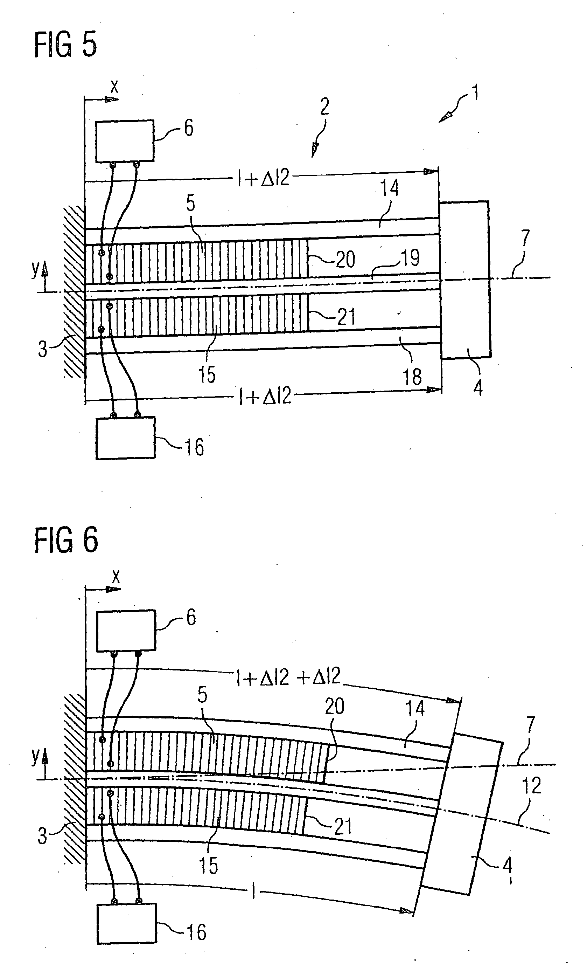

Eine noch effizientere Schwingung der Inertialmasse 4 wird mit dem Inertialkraftgenerator 1 erreicht, der in Fig. 5 und 6 dargestellt ist. Diese zweite Ausführungsform ist weitgehend mit der zweiten Ausführungsform identisch. Ein Unterschied besteht darin, dass bereits in der Ruheposition des Biegearmes 2 beide Wandler 5, 15 so angesteuert sind, dass sie um eine Längenänderung Δl2 ausgelenkt sind, d.h. an den Wandlern 5, 15 liegt eine Vorspannung an. Anschließend wird der erste Aktuator 5 um eine zusätzliche Längenänderung Δl2 verlängert, während der zweite Aktuator 15 um diese Längenänderung Δl2 verkürzt wird, siehe Fig. 6. Der erste Aktuator führt damit eine Längenänderung um Δl2+ Δl2 aus, während der zweite Aktuator keine Längenänderung mehr aufweist. Bei dieser Konstruktion wird der Umstand berücksichtigt, dass ein piezokeramischer Werkstoff ausgehend von seiner Basislänge, bei der kein elektrisches Feld anliegt, nur verlängert werden kann.

In Fig. 7 ist eine besonders bevorzugte Ausführungsform der Erfindung dargestellt. Der Biegearm 2 ist in Faserverbundbauweise ausgebildet. Die Neutrallage 19 und die Außenlagen 14, 18 bestehen aus Faserverbundmaterial, insbesondere aus glasfaserverstärktem Kunststoff (GFK). Die zu beiden Seiten der Wandler 5, 15 angeordneten Distanzelemente 13, 22 bzw. 17, 23 können aus Faserverbundwerkstoffen, anderen Leichtbaumaterialien (z.B. Schaumwerkstoff) oder Metall bestehen. Bei der Herstellung des Biegearms 2 werden zunächst die Wandler 5, 15 beidseitig auf der Neutrallage 19 angebracht, ggf. durch fixieren mittels Kleben. Anschließend werden die Bereiche seitlich der Wandler 5, 15 mit entsprechenden Distanzelementen 13, 22 bzw. 18, 23, die auch aus mehreren Faserverbundwerkstoff-Lagen bestehen können, aufgefüllt. Zum Schutz der piezoelektrischen Aktuatoren 5, 15 werden die Außenlagen 14, 18 angeordnet und abschließend wird die schichtförmige Faserverbundwerkstoff-Anordnung auf bekannte Art und Weise mit einem Harzsystem injiziert und ggf. unter Wärmeeinwirkung ausgehärtet, typischerweise mittels bekanntem Harzinjektionsverfahren, wie beispielsweise dem RTM-Verfahren. Durch die Außenlagen 14 und 18 werden die empfindlichen piezokeramischen Werkstoffe der Aktuatoren 5, 15 vor Feuchtigkeit und dem Eindringen von Fremdkörpern geschützt. Durch entsprechende Wahl der Materialien der Distanzelemente 13, 17, 22 und 23 kann die Eigenfrequenz des Biegearmes 2 mit Wandler 5, 15 und Inertialmasse 4 auf einen gewünschten Wert eingestellt werden. Zudem kann durch geeignete Wahl der Materialien eine besonders leichte Anordnung, bei der die Masse des Biegearms 2 mit Wandler 5, 15 viel kleiner als die Inertialmasse 4 ist, geschaffen werden.

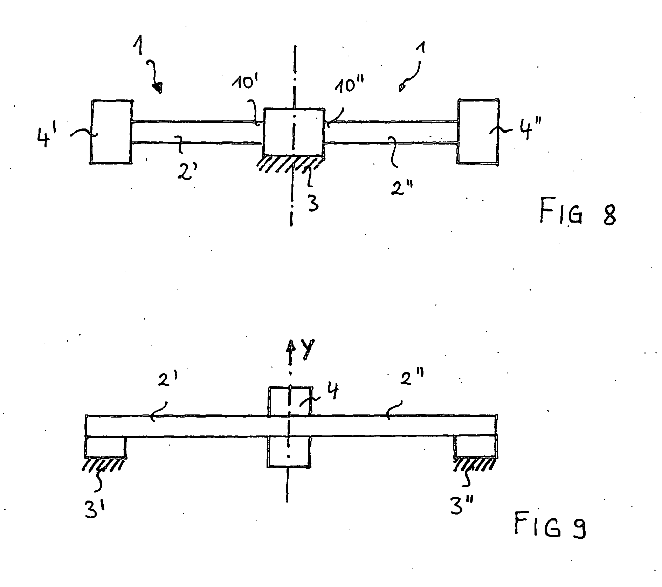

Der voran stehend beschriebene Kraftgenerator kann auch in einer symmetrischen Anordnung verwendet werden, um eine Vorrichtung zur Schwingungsbeeinflussung zu schaffen. In Fig. 8 ist eine erste Ausführungsform mit zwei Kraftgeneratoren schematisch dargestellt, wobei die Biegearme der beiden Kraftgeneratoren in Verlängerung zueinander angeordnet sind. Wie in Fig. 8 zu sehen ist, sind die Biegearme 2', 2" der jeweiligen Kraftgeneratoren 1 derart an der schwingungsmäßig zu beeinflussenden Struktur 3 angeordnet, dass die Inertialmassen 4', 4" in gleichem Abstand von der Befestigungsstelle 10' bzw. 10" entfernt sind. Die Biegearme 2', 2" sind vorzugsweise einstückig ausgebildet, so dass die Vorrichtung zur Schwingungsbeeinflussung im Wesentlichen aus einem Biegearm besteht, an dessen äußeren Enden jeweils die Inertialmassen 4' und 4" angeordnet sind. Der einstückige Biegearm ist dann vorzugsweise in der Mitte an der Struktur 3 angeordnet. Die in Fig. 8 dargestellte Anordnung kann durch entsprechende an den Biegearmen 2', 2" angeordnete Wandler, die in Fig. 8 nicht dargestellt sind, jedoch im Zusammenhang mit den voran stehenden Figuren detailliert beschrieben wurden, derart angesteuert werden, dass die Inertialmassen 4', 4" entweder parallel, d.h. in gleicher Richtung (z.B. in positiv y-Richtung ), oder anti-parallel, d.h. in entgegengesetzte Richtung, ausgelenkt werden. Bei einer parallelen Auslenkung der Inertialmassen 4', 4" können Kräfte sowie Momente in die Struktur 3 eingeleitet werden. Bei einer anti-parallelen Auslenkung erfolgt die Krafteinleitung in die Struktur 3 momentenfrei.

In Fig. 9 ist eine weitere symmetrische Anordnung von erfindungsgemäßen Kraftgeneratoren dargestellt, die eine so genannte "Durchschwinger"-Anordnung zeigt. Betrachtet man den linken Bereich der Fig. 9, so stellt dies einen wie im Zusammenhang mit den Figuren 3 bis 7 beschriebenen Kraftgenerator dar, wobei jedoch der Biegearm 2' quasi über die Inertialmasse 4, d.h. in Fig. 9 nach rechts, verlängert ist, wobei das verlängerte Ende an einer weiteren Struktur 3" bzw. an einer anderen Stelle 3" der Struktur befestigt ist. Mit anderen Worten, die Anordnung gemäß Fig. 9 umfasst im Wesentlichen einen Biegearm, dessen äußere Enden, d.h. das linke sowie das rechte Ende in Fig. 9, an unterschiedlichen Stellen 3' und 3" befestigt sind. Die Inertialmasse 4 ist dabei in der Mitte des Biegearmes angeordnet und wird analog zu der voranstehenden Beschreibung in eine Richtung senkrecht zur Ebene des Biegearmes, d.h. in positiver und negativer y-Richtung, ausgelenkt. Die Einleitung von Schwingungskräften an den Stellen 3' und 3" erfolgt dabei momentenfrei.

## Patentansprüche

1. Kraftgenerator (1), der zur Anbringung an einer Struktur (3) ausgebildet ist, um steuerbar Schwingungskräfte zur Schwingungsbeeinflussung der Struktur (3) in diese einzuleiten, umfassend
einen Biegearm (2), der mindestens an einem Ende (10) an der Struktur (3) befestigbar ist; und
eine Inertialmasse (4), die entfernt vom Befestigungsende (10) des Biegearmes (2) mit dem Biegearm (2) gekoppelt ist;
wobei der Biegearm (2) mit mindestens einem elektromechanischen Wandler (5, 15) versehen ist, und eine Ansteuerung (6, 16) für den Wandler (5, 15) vorgesehen ist, welche eingerichtet ist, durch Ansteuern des Wandlers (5, 15) den Biegearm (2) mit der Inertialmasse (4) und dem Wandler (5, 15) derart zu verbiegen und **dadurch** die Inertialmasse (4) auszulenken, dass Schwingungskräfte mit variabler Amplitude, Phase und Frequenz in die Struktur (3) einleitbar sind,
**dadurch gekennzeichnet, dass**
seitlich beabstandet zur Neutrallage (19) des Biegearms (2), welche entlang der Mittellinie (7, 12) des Biegearms (2) verläuft, eine Außenlage (14, 18) angeordnet ist, und
zumindest zwischen dem Ende des Wandlers (5, 15) und der Inertialmasse (4) ein Distanzelement (13, 17; 13, 17, 22, 23) angeordnet ist,
wobei die Außenlage mit dem Wandler (5, 15) und/oder dem Distanzelement (13, 17; 13, 17, 22, 23) kraftschlüssig und/oder formschlüssig verbunden ist.

2. Kraftgenerator (1) nach Anspruch 1, **dadurch gekennzeichnet, dass** der Wandler (5, 15) derart ansteuerbar ist, dass Schwingungskräfte bei zumindest zwei Frequenzen in die Struktur (3) einleitbar sind.

3. Kraftgenerator (1) nach Anspruch 1 oder 2, **dadurch gekennzeichnet, dass** der Wandler (5, 15) derart ansteuerbar ist, dass der Biegearm (2) mit der Inertialmasse (4) und dem Wandler (5, 15) in eine Schwingung in Eigenfrequenz versetzbar ist.

4. Kraftgenerator (1) nach einem der Ansprüche 1 bis 3, **dadurch gekennzeichnet, dass** die Inertialmasse (4) ein Vielfaches der Masse des Biegearmes (2) und des Wandlers (5, 15) beträgt.

5. Kraftgenerator (1) nach einem der Ansprüche 1 bis 4, **dadurch gekennzeichnet, dass** der Wandler (5, 15) ein piezoelektrischer Aktuator (5, 15) ist, insbesondere ein stapelförmiges Piezoelement mit d33-Effekt.

6. Kraftgenerator (1) nach einem der Ansprüche 1 bis 5, **dadurch gekennzeichnet, dass** der Wandler (5, 15) derart ansteuerbar ist, dass er eine Längenänderung in Längsrichtung des Biegearmes (2) durchführt.

7. Kraftgenerator (1) nach einem der Ansprüche 1 bis 6, **dadurch gekennzeichnet, dass** der Wandler (5, 15) parallel zur Neutrallage (19) angeordnet ist.

8. Kraftgenerator (1) nach Anspruch 7, **dadurch gekennzeichnet, dass** jeweils mindestens ein Wandler (5, 15) auf einander gegenüberliegenden Seiten der Neutrallage (19) angeordnet ist.

9. Kraftgenerator (1) nach einem der Ansprüche 7 oder 8, **dadurch gekennzeichnet, dass** der Wandler (5, 15) mit der Neutrallage (19) kraftschlüssig und/oder formschlüssig verbunden ist.

10. Kraftgenerator (1) nach einem der Ansprüche 1 bis 9, **dadurch gekennzeichnet, dass** der mindestens eine Wandler (5, 15) innerhalb des Biegearms (2) angeordnet ist.

11. Kraftgenerator (1) nach einem der Ansprüche 1 bis 10, **dadurch gekennzeichnet, dass** der Biegearm (2) in Faserverbundbauweise mit darin integriertem Wandler (5, 15) ausgebildet ist.

12. Kraftgenerator (1) nach einem der Ansprüche 1 bis 11, **dadurch gekennzeichnet, dass** der Wandler (5, 15) unter einer Druckvorspannung steht.

13. Kraftgenerator (1) nach Anspruch 12, **dadurch gekennzeichnet, dass** die Druckvorspannung mechanisch aufgeprägt ist.

14. Kraftgenerator (1) nach einem der Ansprüche 11 bis 13, **dadurch gekennzeichnet, dass** der Wandler (5, 15) zur Erzeugung der Druckvorspannung bei der Herstellung thermisch vorbehandelt ist.

15. Kraftgenerator (1) nach einem der Ansprüche 11 bis 14, **dadurch gekennzeichnet, dass** an dem Wandler (5, 15) eine elektrische Offset-Spannung angelegt ist.

16. Verfahren zum Betreiben des Kraftgenerators (1) nach einem der Ansprüche 1 bis 15, **dadurch gekennzeichnet, dass** durch geeignete Ansteuerung des elektromechanischen Wandlers (5, 15) der Biegearm (2) mit der Inertialmasse (4) und dem Wandler (5, 15) derart verbogen wird und **dadurch** die Inertialmasse (4) ausgelenkt wird, dass Schwingungskräfte mit variabler Amplitude, Phase und Frequenz erzeugt werden.

17. Verfahren nach Anspruch 16, **dadurch gekennzeichnet, dass** der Wandler (5, 15) bei mehreren Frequenzen oder über einen vorgegebenen Frequenzbereich angesteuert wird, um Schwingungskräfte bei zumindest zwei Frequenzen in die Struktur (3) einzuleiten.

18. Vorrichtung zur Schwingungsbeeinflussung, die zur Anbringung an zumindest einer Struktur (3) ausgebildet ist, um steuerbar Schwingungskräfte in die Struktur (3) einzuleiten, umfassend zwei Kraftgeneratoren (1) nach einem der Ansprüche 1 bis 15, die derart angeordnet sind, dass der Biegearm (2') des ersten Kraftgenerators (1) in Verlängerung des Biegearms (2") des zweiten Kraftgenerators (1) angeordnet ist.

19. Vorrichtung nach Anspruch 18, **dadurch gekennzeichnet, dass** die beiden Kraftgeneratoren (1) zueinander symmetrisch angeordnet sind.

20. Vorrichtung nach Anspruch 18 oder 19, **dadurch gekennzeichnet, dass** der erste Biegearm (2') und der zweite Biegearm (2") einstückig ausgebildet sind.

21. Vorrichtung nach einem der Ansprüche 18 bis 20, **dadurch gekennzeichnet, dass** das der Inertialmasse (4') gegenüberliegende Ende (10') des ersten Biegearms (2') und das der Inertialmasse (4") gegenüberliegende Ende (10") des zweiten Biegearms (2") an der Struktur (3) befestigt sind.

22. Vorrichtung nach Anspruch 20, **dadurch gekennzeichnet, dass** der einstückig ausgebildete Biegearm an seinen äußeren Enden jeweils mit einer Inertialmasse (4', 4") gekoppelt ist, und in einem Bereich zwischen den beiden Inertialmassen (4', 4") an der Struktur (3) befestigbar ist.

23. Vorrichtung nach Anspruch 20, **dadurch gekennzeichnet, dass** der einstückig ausgebildete Biegearm an seinen äußeren Enden jeweils an zumindest einer Struktur (3', 3") befestigt ist, und in einem Bereich zwischen den beiden Befestigungsstellen zumindest eine Inertialmasse (4) aufweist.

## Claims

1. Force generator (1) configured for attachment to a structure (3) to controllably introduce vibrational forces into the structure (3) for influencing the vibration thereof, comprising
a flexural arm (2) that is fastenable at least at one end (10) to the structure (3); and
an inertial mass (4) that is coupled to the flexural arm (2) remotely from the fastening end (10) of the flexural arm (2);
the flexural arm (2) being equipped with at least one electromechanical transducer (5, 15), and a drive (6, 16) being provided for the transducer (5, 15), which drive is set up such that by driving the transducer (5, 15) the flexural arm (2) with the inertial mass (4) and the transducer (5, 15) is bent, and the inertial mass (4) is thereby deflected, in such a way that vibrational forces of variable amplitude, phase, and frequency are introducible into the structure (3),
**characterised in that**
an outer ply (14, 18) is disposed at a distance laterally from the neutral ply (19) of the flexural arm (2), which neutral ply (19) extends along the centre line (7, 12) of the flexural arm (2), and
a spacing element (13, 17; 13, 17, 22, 23) is disposed at least between the end of the transducer (5, 15) and the inertial mass (4),
the outer ply being connected to the transducer (5, 15) and/or the spacing element (13, 17; 13, 17, 22, 23) non-positively and/or positively.

2. Force generator (1) according to Claim 1, **characterised in that** the transducer (5, 15) is drivable in such a way that vibrational forces at at least two frequencies are introducible into the structure (3).

3. Force generator (1) according to Claim 1 or 2, **characterised in that** the transducer (5, 15) is drivable in such a way that the flexural arm (2) with the inertial mass (4) and the transducer (5, 15) can be caused to vibrate at a resonant frequency.

4. Force generator (1) according to one of Claims 1 to 3, **characterised in that** the inertial mass (4) constitutes a multiple of the mass of the flexural arm (2) and the transducer (5, 15).

5. Force generator (1) according to one of Claims 1 to 4, **characterised in that** the transducer (5, 15) is a piezoelectric actuator (5, 15), in particular a stacked piezoelement having a d33 effect.

6. Force generator (1) according to one of Claims 1 to 5, **characterised in that** the transducer (5, 15) is drivable in such a way that it brings about a change in the length of the flexural arm (2) in the longitudinal direction.

7. Force generator (1) according to one of Claims 1 to 6, **characterised in that** the transducer (5, 15) is disposed parallel to the neutral ply (19).

8. Force generator (1) according to Claim 7, **characterised in that** in each case at least one transducer (5, 15) is arranged on mutually opposite sides of the neutral ply (19).

9. Force generator (1) according to one of Claims 7 or 8, **characterised in that** the transducer (5, 15) is non-positively and/or positively connected to the neutral ply (19).

10. Force generator (1) according to one of Claims 1 to 9, **characterised in that** the at least one transducer (5, 15) is disposed inside the flexural arm (2).

11. Force generator (1) according to one of Claims 1 to 10, **characterised in that** the flexural arm (2) is embodied as a fibre composite design with the transducer (5, 15) integrated therein.

12. Force generator (1) according to one of Claims 1 to 11, **characterised in that** the transducer (5, 15) is under a compressive preload.

13. Force generator (1) according to Claim 12, **characterised in that** the compressive preload is impressed mechanically.

14. Force generator (1) according to one of Claims 11 to 13, **characterised in that** the transducer (5, 15) is thermally pretreated during manufacture so as to produce the compressive preload.

15. Force generator (1) according to one of Claims 11 to 14, **characterised in that** an electrical offset voltage is applied to the transducer (5, 15).

16. Method for operating the force generator (1) according to one of Claims 1 to 15, **characterised in that** by suitable driving of the electromechanical transducer (5, 15) the flexural arm (2) with the inertial mass (4) and the transducer (5, 15) is bent, and the inertial mass (4) is thereby deflected, in such a way that vibrational forces of variable amplitude, phase, and frequency are produced.

17. Method according to Claim 16, **characterised in that** the transducer (5, 15) is driven at multiple frequencies or over a predefined frequency range so as to introduce vibrational forces at at least two frequencies into the structure (3).

18. Device for influencing vibration configured for attachment to at least one structure (3) to controllably introduce vibrational forces into the structure (3), comprising two force generators (1) according to one of Claims 1 to 15, which are disposed in such a way that the flexural arm (2') of the first force generator (1) is disposed as an extension of the flexural arm (2") of the second force generator (1).

19. Device according to Claim 18, **characterised in that** the two force generators (1) are disposed symmetrically with respect to each other.

20. Device according to Claim 18 or 19, **characterised in that** the first flexural arm (2') and the second flexural arm (2") are formed in one piece.

21. Device according to one of Claims 18 to 20, **characterised in that** the end (10') of the first flexural arm (2') opposite the inertial mass (4') and the end (10") of the second flexural arm (2") opposite the inertial mass (4") are fastened to the structure (3).

22. Device according to Claim 20, **characterised in that** the flexural arm formed in one piece is coupled at its outer ends in each case to an inertial mass (4', 4"), and is fastenable in a region between the two inertial masses (4', 4") to the structure (3).

23. Device according to Claim 20, **characterised in that** the flexural arm formed in one piece is fastened at its outer ends in each case to at least one structure (3', 3"), and has at least one inertial mass (4) in a region between the two fastening points.

## Revendications

1. Générateur de force (1), qui est conçu pour être monté sur une structure (3) afin d'induire dans celle-ci des forces oscillantes commandables en vue d'agir sur les vibrations de la structure (3), comprenant un bras flexible (2), qui peut être fixé à au moins une extrémité (10) à la structure (3), et une masse d'inertie (4), qui est accouplée au bras flexible (2) à distance de l'extrémité de fixation (10) du bras flexible (2), le bras flexible (2) étant muni d'au moins un convertisseur électromécanique (5, 15), et une commande (6, 16) étant prévue pour le convertisseur (5, 15), pour plier le bras flexible (2) avec la masse d'inertie (4) et le convertisseur (5, 15) et ainsi dévier la masse d'inertie (4), en commandant le convertisseur de telle sorte que des forces oscillantes à amplitude, phase et fréquences variables puissent être induites dans la structure (3), **caractérisé en ce qu'**une couche extérieure (14, 18) est disposée, de façon à être écartée latéralement de la couche neutre (19) du bras flexible (2), qui passe le long de la ligne médiane (7,12) du bras flexible (2) et au moins un élément d'écartement (13, 17; 13, 17, 22, 23) est disposé entre l'extrémité du convertisseur (5, 15) et la masse d'inertie (4), la couche extérieure étant reliée au convertisseur (5, 15) et/ou à l'élément d'écartement (13, 17; 13, 17, 22, 23) par une liaison par complémentarité de formes et/ou par action de force.

2. Générateur de force (1) selon la revendication 1, **caractérisé en ce que** le convertisseur (5, 15) peut être commandé de telle sorte que des forces oscillantes puissent être induites à au moins deux fréquences dans la structure (3).

3. Générateur de force (1) selon la revendication 1 ou 2, **caractérisé en ce que** le convertisseur (5, 15) peut être commandé de telle sorte que le bras flexible (2) est mobile avec la masse d'inertie (4) et le convertisseur (5, 15) pour former une oscillation dans sa fréquence propre.

4. Générateur de force (1) selon l'une quelconque des revendications 1 à 3, **caractérisé en ce que** la masse d'inertie (4) est un multiple de la masse du bras flexible (2) et du convertisseur (5, 15).

5. Générateur de force (1) selon l'une quelconque des revendications 1 à 4, **caractérisé en ce que** le convertisseur (5, 15) est un actionneur piézoélectrique (5, 15), notamment un élément piézoélectrique à structure empilée, à effet longitudinal (correspondant au coefficient d₃₃).

6. Générateur de force (1) selon l'une quelconque des revendications 1 à 5, **caractérisé en ce que** le convertisseur (5, 15) peut être commandé de telle sorte qu'il exécute une variation en longueur dans le sens longitudinal du bras flexible (2).

7. Générateur de force (1) selon l'une quelconque des revendications 1 à 6, **caractérisé en ce que** le convertisseur (5, 15) est disposé de façon à être parallèle à la couche neutre (19).

8. Générateur de force (1) selon la revendication 7, **caractérisé en ce qu'**à chaque fois au moins un convertisseur (5,15) est disposé sur des côtés réciproquement opposés de la couche neutre (19).

9. Générateur de force (1) selon l'une quelconque des revendications 7 ou 8, **caractérisé en ce que** le convertisseur (5, 15) est relié à la couche neutre (19) par une liaison par complémentarité de formes et/ou par action de force.

10. Générateur de force (1) selon l'une quelconque des revendications 1 à 9, **caractérisé en ce que** le au moins un convertisseur (5, 15) est disposé à l'intérieur du bras flexible (2).

11. Générateur de force (1) selon l'une quelconque des revendications 1 à 10, **caractérisé en ce que** le bras flexible (2) est construit dans un mode de construction renforcé par des fibres, le convertisseur (5, 15) étant intégré à l'intérieur.

12. Générateur de force (1) selon l'une quelconque des revendications 1 à 11, **caractérisé en ce que** le convertisseur (5, 15) est soumis à une précontrainte de pression.

13. Générateur de force (1) selon la revendication 12, **caractérisé en ce que** la précontrainte de pression est empreinte mécaniquement.

14. Générateur de force (1) selon l'une quelconque des revendications 1 à 13, **caractérisé en ce que** le convertisseur (5,15) est soumis lors de sa fabrication à un traitement thermique pour générer la précontrainte de pression.

15. Générateur de force (1) selon l'une quelconque des revendications 1 à 14, **caractérisé en ce qu'**une tension électrique de décalage est appliquée au convertisseur (5, 15).

16. Procédé pour faire fonctionner un générateur de force (1) selon l'une quelconque des revendications 1 à 15, **caractérisé en ce que**, par une commande appropriée du convertisseur électromagnétique (5, 15), le bras flexible (2) est plié avec la masse d'inertie (4) et le convertisseur (5, 15) et ainsi la masse d'inertie (4) est déviée de telle sorte que des forces oscillantes à amplitude, phase et fréquences variables sont générées.

17. Procédé selon la revendication 16, **caractérisé en ce que** le convertisseur (5, 15) est commandé à plusieurs fréquences ou à une plage de fréquences prescrite, afin d'induire des forces oscillantes à au moins deux fréquences dans la structure (3).

18. Dispositif agissant sur les vibrations, qui est conçu pour être monté sur au moins une structure (3) afin d'induire dans la structure (3) des forces oscillantes commandables, comprenant deux générateurs de force (1) selon l'une quelconque des revendications 1 à 15, qui sont disposés de telle sorte que le bras flexible (2') du premier générateur de force (1) est disposé dans le prolongement du bras flexible (2") du second générateur de force (1).

19. Dispositif selon la revendication 18, **caractérisé en ce que** les deux générateurs de force (1) sont disposés symétriquement l'un par rapport à l'autre.

20. Dispositif selon la revendication 18 ou 19, **caractérisé en ce que** le premier bras flexible (2') et le second bras flexible (2") sont construits d'une seule pièce.

21. Dispositif selon l'une quelconque des revendications 18 à 20, **caractérisé en ce que** l'extrémité (10') opposée à la masse d'inertie (4') du premier bras flexible (2') et l'extrémité opposée (10") à la masse d'inertie (4") du second bras flexible (2") sont fixées à la structure (3).

22. Dispositif selon la revendication 20, **caractérisé en ce que** le bras flexible construit d'une seule pièce est accouplé à ses extrémités extérieures respectivement à une masse d'inertie (4', 4"), et peut être fixé à la structure (3) dans une zone comprise entre les deux masses d'inertie (4', 4").

23. Dispositif selon la revendication 20, **caractérisé en ce que** le bras flexible construit d'une seule pièce est fixé à ses extrémités extérieures respectivement à au moins une structure (3', 3"), et comprend dans une zone située entre les deux endroits de fixation au moins une masse d'inertie (4).
